# EUROPEAN PATENT SPECIFICATION

(11) **EP 2 600 419 B1**
(45) Date of publication and mention of the grant of the patent: **28.11.2018**
(21) Application number: 11812620.0
(22) Date of filing: 29.07.2011
(51) Int. Cl.: H01L 31/042

(54) **SOLAR CELL MODULE**
SOLARZELLENMODUL
MODULE DE CELLULES SOLAIRES

(30) Priority: 30.07.2010 JP 2010171388
(43) Date of publication of application: 05.06.2013
(73) Proprietor: Panasonic Intellectual Property Management Co., Ltd., Osaka-shi, Osaka 540-6207 (JP)
(72) Inventor: NAKATANI Shihomi, Moriguchi-shi Osaka 570-8677 (JP)
(74) Representative: Glawe, Delfs, Moll
(86) International application number: PCT/JP2011/067439
(87) International publication number: WO 2012/015031

(56) References cited:
- EP-A1- 0 848 449
- EP-A1- 1 998 379
- JP-A- 2001 053 318
- JP-A- 2001 308 352
- JP-A- 2003 086 820
- JP-A- 2006 019 440
- JP-A- 2006 019 440
- JP-A- 2008 042 181
- JP-A- 2008 252 051

## Description

### TECHNICAL FIELD

The invention relates to a solar cell module.

### BACKGROUND ART

A solar cell can convert clean and unlimitedly-supplied solar energy directly into electric energy and is therefore expected to be a new energy source.

The output power of a single solar cell is generally on the order of several watts. Thus, when solar cells are used as a power source of a house, a building, or the like, a solar cell module is used in which multiple solar cells are connected to increase the output power. The solar cell module has a structure in which multiple solar cells are connected in series and/or in parallel by wiring members (inner leads) electrically connected to electrodes of the solar cells.

The solar cells are connected together in such a way that electrodes of each two adjacent solar cells are connected to each other by wiring members . A solar cell string is formed by connecting plural adjacent solar cells as described above. The solar cell module is formed by electrically coupling multiple solar cell strings. In the solar cell strings, the wiring members located in end portions of the respective solar cell strings are electrically connected to each other by a connecting wire with solder. Moreover, the connecting wire is used also as wiring for delivering a generated output power from all of the solar cell strings to the outside. Thus, the connecting wire is soldered to a conductive body electrically coupled to an external output portion to collect the generated output power from the wiring members and to output the collected output power to the outside of the solar cell module. Such a solar cell module is proposed in, for example, Patent Document 1.

A solar cell module is generally manufactured in the following way. A translucent substrate, sealing material, multiple solar cell strings, sealing material, and a back-surface protection film are stacked in this order and the thus-obtained laminated body is heated and pressed by a laminating device.

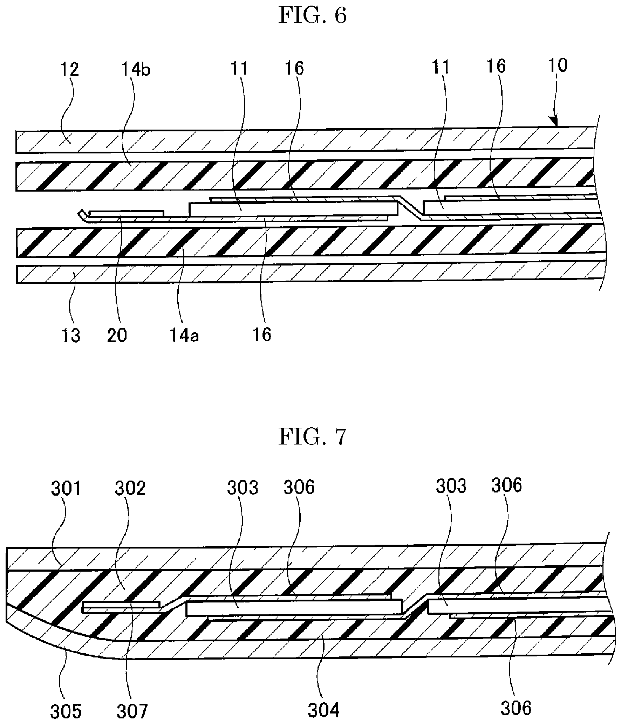

Fig. 7 is a schematic cross-sectional view showing a conventional solar cell module. The solar cell module includes front-surface protection member 301 made of a transparent member such as glass, solar cells 303, transparent sealants 302, 304, and back-surface protection film 305.

In this solar cell module, solar cell strings are formed by electrically connecting electrodes of multiple solar cells 303 to one another by wiring members 306, and the solar cell strings are electrically connected to each other by connecting wire 307. Then, the solar cell strings and connecting wire 307 are sealed with transparent sealants 302, 304 while being interposed between front-surface protection member 301 and back-surface protection film 305.

In the solar cell strings, wiring members 306, 306 located in end portions of the respective solar cell strings are electrically connected to each other via connecting wire 307 with solder. As shown in Fig. 7, there is a case where an edge of an end of each wiring member 306 is located on the back-surface protection film 305 side.

### PRIOR ART DOCUMENT

### PATENT DOCUMENT

Patent Document 1: Japanese Patent Application Publication No. 2005-79170

A solar cell module according to the preamble of claim 1 is disclosed in EP 1998379 A1, JP 2006 019440 A and JP 2008 252051 A.

### SUMMARY OF THE INVENTION

### PROBLEM TO BE SOLVED BY THE INVENTION

In the case where the end edge of each wiring member 306 is located on the back-surface protection film 305 side as described above, back-surface protection film 305 may be damaged by the end edge of wiring member 306 due to pressure application in the laminating step mentioned above. A damage on back-surface protection film 305 makes the solar cell module rejected as a defective product, which causes reduction in yield.

The invention has been made in view of drawbacks of the conventional case described above and an object thereof is to provide a solar cell module in which a back-surface protection film is prevented from being damaged.

### MEANS FOR SOLVING THE PROBLEM

The invention provides a solar cell module according to claim 1.

### EFFECTS OF THE INVENTION

The invention can prevent the back-surface protection film from being damaged by the end edge of the wiring member, and thus can drastically reduce the defective product rate of the solar cell module due to a damage.

### BRIEF DESCRIPTION OF THE DRAWINGS

[Fig. 1] Fig. 1 is an enlarged cross-sectional view of a main portion of a solar cell module in an example.
[Fig. 2] Fig. 2 is an enlarged cross-sectional view of a main portion of a solar cell module in the example.
[Fig. 3] Fig. 3 is a plan view showing a connecting wire portion of the solar cell module in the example.
[Fig. 4] Fig. 4 is an enlarged cross-sectional view of a main portion of a solar cell module in a second example.
[Fig. 5] Fig. 5 is an enlarged cross-sectional view of a main portion of a solar cell module in a third example.
[Fig. 6] Fig. 6 is an enlarged cross-sectional view of the main portion of the solar cell module in the third example in a step of manufacturing the solar cell module.
[Fig. 7] Fig. 7 is a schematic cross-sectional view showing a conventional solar cell module.

### MODES FOR CARRYING OUT THE INVENTION

Examples and an embodiment of the invention are described in detail with reference to the drawings. The same or corresponding portions are denoted by the same reference numerals and description thereof is omitted to avoid overlapping description. Note that the drawings are schematic and proportions of dimensions and the like are different from actual ones. Accordingly, specific dimensions and the like should be determined in consideration of the description below. Moreover, parts where relations and proportions of the dimensions are different among the drawings are included as a matter of course.

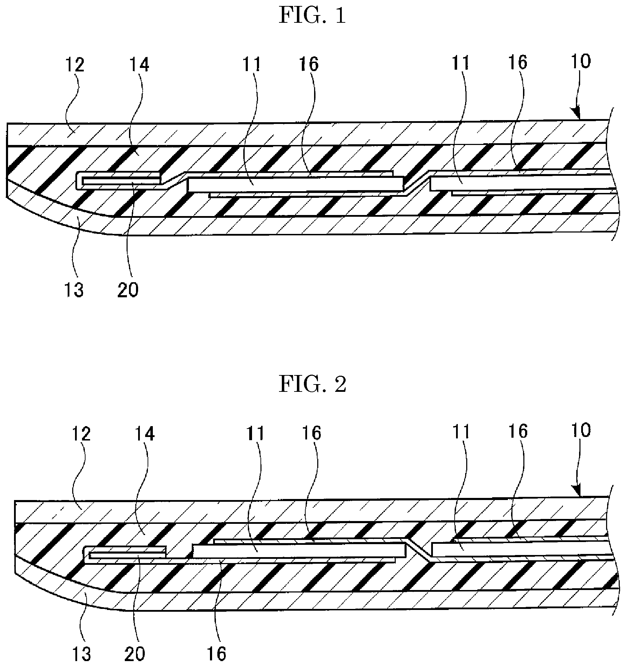

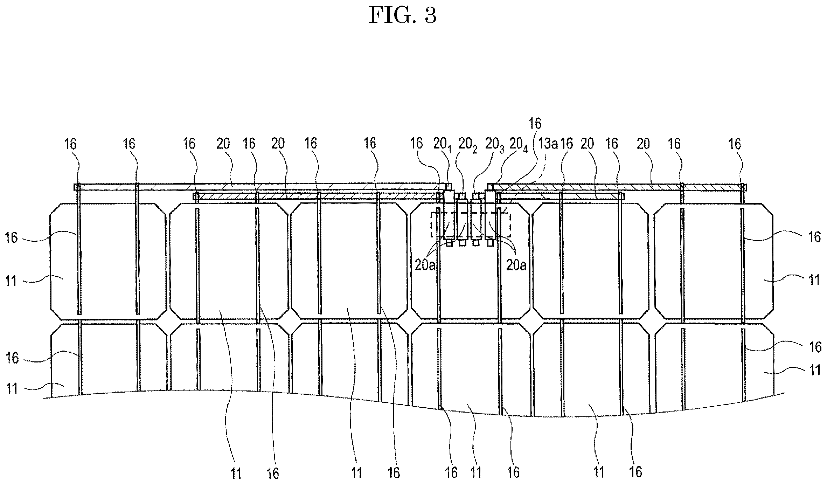

A schematic configuration of solar cell module 10 in an example not according to the invention is described with reference to Figs. 1 to 3. Figs. 1 and 2 are each an enlarged cross-sectional view of a main portion of solar cell module 10 in the example and Fig. 3 is a plan view showing a wiring portion of the solar cell module in the example.

Solar cell module 10 includes solar cells 11, front-surface protection member 12, and back-surface protection film 13, and sealant 14. Solar cell module 10 is formed by sealing multiple solar cells 11 between front-surface protection member 12 and back-surface protection film 13.

Multiple solar cells 11 are connected to one another by wiring members 16. Connection of solar cells 11 and wiring members 16 is achieved by using solder or resin adhesive.

Each of solar cells 11 has a light-receiving surface on which light is incident and a back surface which is provided on the opposite side to the light-receiving surface. Electrodes are formed on the light-receiving surface and the back surface of each solar cell 11.

For example, each solar cell 11 is made of a crystalline semiconductor made of single-crystal silicon, polycrystal silicon, or the like and has a substantial square shape. However, solar cell 11 is not limited to this and a different type of solar cell may be used.

Moreover, the following solar cell may be used as solar cell 11. For example, solar cell 11 has an n-type region and a p-type region such that a junction portion for forming an electric field for carrier separation is formed in an interface portion between the n-type region and the p-type region. Examples of such a solar cell include a solar cell having a structure in which a substantially intrinsic amorphous silicon layer is interposed between a single-crystal silicon substrate and an amorphous silicon layer and defects in an interface therebetween are reduced to improve characteristics of a hetero-junction interface.

Each of wiring members 16 is connected to the electrode on the light-receiving surface of one of solar cells 11 and to the electrode on the back surface of another solar cell 11 adjacent to the one solar cell 11. The adjacent solar cells 11, 11 are thereby electrically connected to each other. Each wiring member 16 includes a thin-plate-shaped copper foil and solder plated on a surface of the copper foil.

When wiring members 16 are connected to solar cells 11 by using the solder, the solder plated on the surface of wiring members 16 is melted and connected to the electrodes of solar cells 11.

Meanwhile, when resin adhesive is used, the resin adhesive is disposed between wiring members 16 and solar cells 11 and wiring members 16 and solar cells 11 are connected together with the resin adhesive. It is preferable that the resin adhesive cures at a temperature equal to or below the melting point of eutectic solder, i.e. equal to or below about 200°C. For example, an anisotropic conductive adhesive film is used as the resin adhesive. A film including at least a resin adhesive component and conductive particles dispersed therein is used as the conductive adhesive film.

A composition containing thermosetting resin is used as the resin adhesive component. For example, epoxy resin, phenoxy resin, acryl resin, polyimide resin, polyamide resin, and polycarbonate resin can be used as the resin adhesive component. These thermosetting resins may be used alone or in a combination of two or more kinds. One or more of thermosetting resins selected from a group including epoxy resin, phenoxy resin, and acryl resin are preferably used.

For example, metal particles such as gold particles, silver particles, copper particles, and nickel particles are used as the conductive particles. Alternatively, conductive particles formed by covering surfaces of insulative or conductive core particles with conductive layers such as metal layers, which include particles such as gold-plated particles, copper-plated particles, and nickel-plated particles, are used as the conductive particles.

Front-surface protection member 12 is disposed on the light-receiving surface side of sealant 14 and protects the front surface of solar cell module 10. A glass which is transparent and which has water blocking properties, a transparent plastic, or the like can be used as front-surface protection member 12.

Back-surface protection film 13 is disposed on the back surface side of sealant 14 and protects the back surface of solar cell module 10. A resin film such as a PET (Polyethylene Terephthalate) film or a multilayer film having such a structure that an Al (aluminum) foil is interposed between these resin films can be used as back-surface protection film 13. In the example shown in Figs. 1 and 2, back-surface protection film 13 is made of a resin film such as a PET film.

Sealant 14 is used to seal solar cells 11 between front-surface protection member 12 and back-surface protection film 13. Transparent resins such as EVA (Ethylence-Vinyl Acetate), EEA (Ethylene-Ethylacrylate Copolymer), PVB (Polyvinyl Butyral), silicon, urethane, acryl, epoxy and the like can be used for sealant 14. In this example, EVA resin is used.

A frame (not illustrated) made of Al (aluminum) or the like can be attached to an outer periphery of solar cell module 10 having the configuration described above.

Wiring member 16 located at an end portion of each of solar cell strings is connected to connecting wire 20, to connect the solar cell strings to each other. Connecting wire 20 is used also as wiring for delivering generated output power from all of the solar cell strings to the outside. Output connecting wire 20 for delivering generated output power to the outside is connected to a terminal of a terminal box (not illustrated) for the power output from solar cells 11. Connecting wire 20 is generally formed of a copper foil with a thickness of about 0.1 mm to 0.3 mm and a width of 6 mm, the copper foil being covered entirely with solder, cut to a predetermined length. Connecting wire 20 is soldered to wiring member 16.

In the example, wiring member 16 is disposed to run around from the back surface to the front surface of connecting wire 20 in such a way that an edge of an end of wiring member 16 is not located on the back-surface protection film 13 side but is located on the front-surface protection member 12 side of connecting member 20.

Specifically, wiring member 16 is provided as follows. As shown in Figs. 1 and 2, wiring member 16 is bent at an end of connecting wire 20 to run around from the back surface to the front-surface protection member 12 side of connecting wire 20 via a lateral side surface of connecting wire 20. The end portion of connecting wire 20 is thus located on the front-surface protection member 12 side. Fig. 1 shows that wiring member 16 that is connected to the front-surface protection member 12 side of solar cell 11 is connected to connecting wire 20. Moreover, Fig. 2 shows that wiring member 16 that is connected to the back-surface protection film 13 side of solar cell 11 is connected to connecting wire 20.

Then, six strings thus formed are connected in series as shown in Fig. 3. The leftmost string is connected to output connecting wire 20₁ and the second and third strings from the left are connected to output connecting wire 20₂. Moreover, the rightmost string is connected to output connecting wire 20₄ and the second third strings from the right are connected to output connecting wire 20₃. In end portions of the solar cell strings which are not illustrated in Fig.3, wiring members 16 of adjacent solar cells are connected to each other by connecting wires 20. Specifically, the rightmost solar cell string and the second solar cell string from the right, the third solar cell string from the right and the third solar cell string from the left, and the leftmost solar cell string and the second solar cell string from the left are electrically connected to each other.

Output connecting wires 20₁ to 20₄ thus connected to the six strings are lead out from opening portion 13a of back-surface protection film 13.

Solar cell module 10 is formed by stacking front-surface protection member 12, an EVA sheet (sealant) on the front surface side, multiple solar cells 11 connected together by wiring members 16 and connecting wires 20 as described above, an EVA sheet (sealant), and back-surface protection film 13 in this order from a lower side.

Specifically, after being stacked as described above, the constituent parts are pressed by a laminating device and thereafter heated a temperature between about 130°C and about 200°C. The EVA sheets are thereby turned into a gel and predetermined EVA layer (sealing layer) 14 is formed. As a result, solar cells 11... are sealed in EVA layer (sealing layer) 14 while being interposed between front-surface protection member 12 on the front surface side and back-surface protection film 13 on the back surface side.

Thereafter, the terminal box is attached to back-surface protection film 13 with silicone resin in such a way as to cover opening portion 13a of back-surface protection film 13. Then, output connecting wires 20 lead out from opening portion 13a are connected to a terminal block in the terminal box. Solar cell module 10 is thereby configured to be connectable to an external circuit and is completed.

A back-flow preventing diode is connected between terminals of the terminal box to which output connecting wires 20₁ to 20₄ are connected. Moreover, insulating material 20a for insulation is attached to each of output connecting wires 20₁ to 20₄.

In the first example, wiring member 16 is set to have a length long enough to completely cover the front and back sides of connecting wire 20 as described above. Connection between wiring member 16 and connecting wire 20 is achieved by the solder provided on the front and back sides of connecting wire 20. As a result, wiring member 16 is bonded to the front surface and the back surface of connecting wire 20 and the bonding strength between wiring member 16 and connecting wire 20 can be thereby increased.

Moreover, even during the pressure application in the laminating step, the bent portion of wiring member 16 is opposed to back-surface protection film 13 and the end edge of wiring member 16 is disposed located on the front-surface protection member 12 side. Accordingly, back-surface protection film 13 is prevented from being damaged by the corner portion of wiring member 16. As a result, the defective product rate of the solar cell module can be drastically reduced.

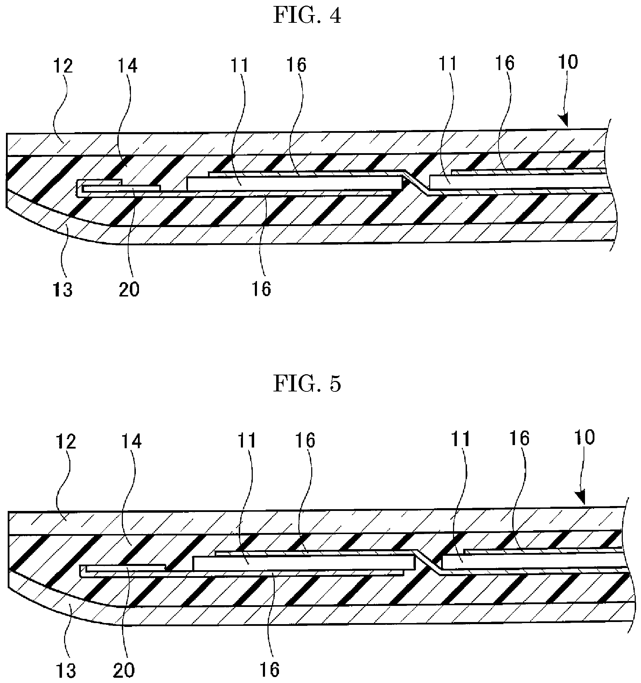

Wiring member 16 is disposed to run around from the back surface of connecting wire 20 to the front surface (the front-surface protection member 12 side) of connecting wire 20, and the end edge of wiring member 16 reaches an end portion of connecting wire 20 that is adjacent to solar cell 11. In contrast, in a second example not according to the invention shown in Fig. 4, wiring member 16 is provided to have such a length that wiring member 16 reaches a middle of connecting wire 20 on the front-surface protection member 12 side of connecting wire 20. A damage on back-surface protection film 13 can be also prevented even by using wiring member 16 having such a length.

Next, description is given of a third example which is an embodiment of the invention. In the third example, as shown in Fig. 5, wiring member 16 is bent at an end of connecting wire 20 to run around from the back surface of connecting wire 20 to the lateral side surface of connecting wire 20 so that an end portion of wiring member 16 extends toward front-surface protection member 12. Also, such a configuration can prevent a damage on back-surface protection film 13 by wiring member 16.

In the third example, as shown in Fig. 6, at the end of connection wiring 20, wiring member 16 is bent to run around from the back surface of connecting wire 20 to the lateral side surface of connecting wire 20. As a result, the end portion of wiring member 16 is not opposed to back-surface protection film 13. Wiring member 16 and connecting wire 20 are connected to each other in this state.

Then, as shown in Fig. 6, solar cell module 10 is formed by stacking front-surface protection member 12, EVA sheet (sealant) 14a on the front surface side, multiple solar cells 11 and connecting wire 20 which are connected together by wiring members 16, EVA sheet (sealant) 14b, and back-surface protection film 13 in this order from a lower side.

After being stacked as described above, the constituent parts are pressed by a laminating device and thereafter heated a temperature between about 130°C and about 200°C. EVA sheets 14a, 14b are thereby turned into a gel and predetermined EVA layer (sealing layer) 14 is formed. As a result, solar cells 11... are sealed in EVA layer (sealing layer) 14 while being interposed between front-surface protection member 12 on the front surface side and back-surface protection film 13 on the back surface side and solar cell module 10 is thus completed.

In the third example, as shown in Fig. 5, lamination is performed with the end edge of wiring member 16 not opposed to back-surface protection film 13 as described above. Hence, back-surface protection film 13 is prevented from being damaged.

It should be conceived that the examples disclosed herein are exemplary in all points and do not limit the invention. For example, the invention is not limited to the case of using the solar cells having electrodes on the light-receiving surface and the back surface, which are used herein. Solar cells having electrodes only on the back surfaces may be used. Moreover, the scope of the invention is not defined by the above description of the embodiment but by the claims and it is intended that the scope of invention includes equivalents of claims and all modifications within the scope of claims.

### EXPLANATION OF THE REFERENCE NUMERALS

- 10: solar cell module
- 11: solar cell
- 12: front-surface protection member
- 13: back-surface protection film
- 13a: opening portion
- 14: sealant
- 16: wiring member
- 20: connecting wire

## Claims

1. A solar cell module (10) comprising:
a front-surface protection member (12);
a back-surface protection film (13);
a plurality of solar cells (11) provided between the front-surface protection member (12) and the back-surface protection film (13) and electrically connected to one another by first wiring members (16);
a sealant (14) sealing the plurality of solar cells (11) between the front-surface protection member (12) and the back-surface protection film (13); and
a connecting wire (20) electrically connected to a second wiring member (16) located at an end portion of a string of the plurality of solar cells, wherein
the second wiring member (16) is connected to the connecting wire (20) in such a way that a bent portion of the second wiring member (16) is disposed to be opposed to the back-surface protection film (13);
**characterized in that** the second wiring member (16) is bent at an end of the connecting wire (20) to run around from the back surface of the connecting wire (20) to the lateral side surface of the connecting wire (20) so that an end portion of the second member (16) extends toward the front-surface protection member (12).

2. The solar cell module (10) according to claim 1, wherein the second wiring member (16) is connected in a state of being bent from a back surface side of the connecting wire (20) to a front surface side of the connecting wire (20).

3. The solar cell module (10) according to claim 1, wherein the length of the second wiring member (16) is set such that an end portion of the second wiring member (16) faces the front-surface protection member (12).

## Patentansprüche

1. Solarzellenmodul (10), das Folgendes umfasst:
ein Vorderseitenschutzelement (12);
einen Rückseitenschutzfilm (13);
eine Anzahl an Solarzellen (11), die zwischen dem Vorderseitenschutzelement (12) und dem Rückseitenschutzfilm (13) bereitgestellt sind und durch erste Verdrahtungselemente (16) elektrisch miteinander verbunden sind;
ein Versiegelungsmittel (14), das die Anzahl an Solarzellen (11) zwischen dem Vorderseitenschutzelement (12) und dem Rückseitenschutzfilm (13) versiegelt, und
einen Verbindungsdraht (20), der mit einem zweiten Verdrahtungselement (16), das an einem Endteil einer Reihe der Anzahl an Solarzellen angeordnet ist, elektrisch verbunden ist, wobei das zweite Verdrahtungselement (16) mit dem Verbindungsdraht (20) auf eine solche Weise verbunden ist, dass ein gebogener Teil des zweiten Verdrahtungselements (16) so angeordnet ist, dass er dem Rückseitenschutzfilm (13) entgegengesetzt ist;
**dadurch gekennzeichnet, dass** das zweite Verdrahtungselement (16) an einem Ende des Verbindungsdrahts (20) so gebogen ist, dass es um die hintere Oberfläche des Verbindungsdrahts (20) herum zu der lateralen Seitenoberfläche des Verbindungsdrahts (20) läuft, sodass ein Endteil des zweiten Elements (16) sich in Richtung des Vorderseitenschutzelements (12) erstreckt.

2. Solarzellenmodul (10) gemäß Anspruch 1, wobei das zweite Verdrahtungselement (16) in einem Zustand, in dem es von einer Rückoberflächenseite des Verbindungsdrahts (20) zu einer Vorderoberflächenseite des Verbindungsdrahts (20) gebogen ist, verbunden ist.

3. Solarzellenmodul (10) gemäß Anspruch 1, wobei die Länge des zweiten Verdrahtungselements (16) so festgesetzt ist, dass ein Endteil des zweiten Verdrahtungselements (16) dem Vorderseitenschutzelement (12) gegenübersteht.

## Revendications

1. Module photovoltaïque (10) comprenant :
un élément de protection de surface avant (12) ;
un film de protection de surface arrière (13) ;
une pluralité de cellules photovoltaïques (11) placées entre l'élément de protection de surface avant (12) et le film de protection de surface arrière (13) et connectées électriquement les unes aux autres par des premiers éléments de câblage (16) ;
un isolant (14) isolant la pluralité de cellules photovoltaïques (11) entre l'élément de protection de surface avant (12) et le film de protection de surface arrière (13) ; et
un fil de connexion (20) connecté électriquement à un second élément de câblage (16) situé au niveau d'une partie d'extrémité d'un chapelet de la pluralité de cellules photovoltaïques,
le second élément de câblage (16) étant connecté au fil de connexion (20) de telle sorte qu'une partie courbée du second élément de câblage (16) soit disposée de façon à être opposée au film de protection de surface arrière (13) ;
**caractérisé en ce que** le second élément de câblage (16) est courbé au niveau d'une extrémité du fil de connexion (20) afin de s'étendre de la surface arrière du fil de connexion (20) à la surface latérale du fil de connexion (20) de telle sorte qu'une partie d'extrémité du second élément (16) s'étende en direction de l'élément de protection de surface avant (12).

2. Module photovoltaïque (10) selon la revendication 1, dans lequel le second élément de câblage (16) est connecté dans un état dans lequel il est courbé du côté de surface arrière du fil de connexion (20) à un côté de surface avant du fil de connexion (20).

3. Module photovoltaïque (10) selon la revendication 1, dans lequel la longueur du second élément de câblage (16) est définie de telle sorte qu'une partie d'extrémité du second élément de câblage (16) se trouve face à l'élément de protection de surface avant (12).
